# FASCICULE DE BREVET EUROPEEN

(11) **EP 0 506 528 B1**
(45) Date de publication et mention de la délivrance du brevet: **31.07.1996**
(21) Numéro de dépôt: 92400753.7
(22) Date de dépôt: 20.03.1992
(51) Int. Cl.: G02F 1/136, H01L 27/12

(54) **Structure de commande matricielle pour écran de visualisation**
Matrix-Ansteuerungsstruktur für Anzeigeschirm
Matrix driving structure for display screen

(30) Priorité: 26.03.1991 FR 9103625
(43) Date de publication de la demande: 30.09.1992
(73) Titulaire: THOMSON-CSF, 75008 Paris (FR)
(72) Inventeur: Lehureau, Jean-Claude, F-92045 Paris la Défense (FR)
(74) Mandataire: Guérin, Michel

(56) Documents cités:
- EP-A- 0 348 209
- US-A- 4 537 471

## Description

La présente invention se rapporte à des écrans de visualisation comprenant une couche de matériau électrooptique, par exemple une couche de cristal liquide.

Comme il est connu, ces écrans comportent généralement un grand nombre d'éléments d'image de forme carrée ou rectangulaire. La définition de l'écran est fonction du nombre de points susceptibles de recevoir une information. La commande de chaque point se fait par application d'un champ électrique. Pour la visualisation d'informations vidéo, il a été proposé des affichages de type matriciel. Chaque élément d'image est alors défini par l'intersection de deux réseaux de conducteurs orthogonaux appelés lignes et colonnes. On parvient alors à réduire le nombre de connexions de M éléments, d'une valeur M à deux fois la racine carrée de M. Par contre le matriçage pose de sérieux problèmes au niveau de la commande de l'écran et du matériau électrooptique chargé de convertir le signal électrique en signal visuel. En effet, dans ce type d'adressage on ne peut adresser simultanément que les points d'une même ligne i, en appliquant sur cette ligne une tension excitative Vi et sur les colonnes, des tensions Vj qui dépendent de l'état que doivent prendre les points (i,j). Chaque ligne de l'écran est excitée séquentiellement pendant un temps t = T/N où T est le temps d'adressage de l'écran et N le nombre de lignes. Si le matériau électrooptique ne possède pas de mémoire propre, il faut maintenir l'information en revenant périodiquement exciter les points allumés. La valeur maximale de cette période T de rafraîchissement est fixée, physiologiquement à 40 ms environ. Donc le temps t consacré à l'excitation d'un point est t = 40/N ms et devient très court lorsque N augmente.

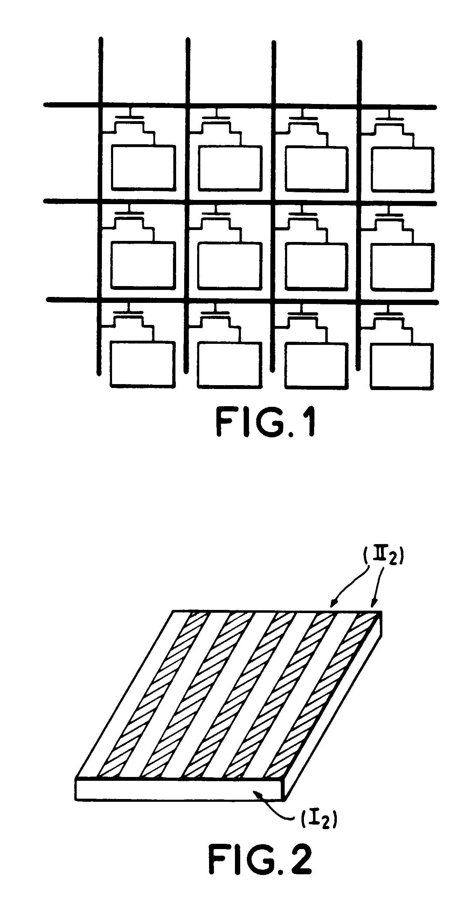

Une des solutions envisagées pour pallier ce problème est d'utiliser des écrans à commande active pour lesquels le matériau électrooptique est placé en série avec un commutateur électronique (diodes, transistors) notamment décrit dans la demande de brevet publiée EP A 0 348 209. La mémoire d'image peut ainsi être constituée de deux réseaux de conducteurs lignes et colonnes à la croisée desquels se trouvent par exemple un transistor de commutation relié au condensateur formé par le matériau électrooptique et ses électrodes de commande (figure 1). Dans ce cas, la grille du transistor est reliée à l'électrode ligne, la source à l'électrode colonne sur laquelle transite le signal vidéofréquence. Lorsqu'une ligne i est excitée, une tension est appliquée de façon à rendre conducteurs tous les transistors de la ligne. Les capacités de cellules électrooptiques se chargent aux tensions vidéo appliquées sur les colonnes. Quand la ligne i cesse d'être excitée, les transistors sont bloqués, et les informations maintenues dans les condensateurs de la ligne précédemment adressée.

L'amélioration des performances d'un écran à TFT (thin film transistors) par rapport à un écran à adressage direct se fait néanmoins au prix d'une complexité technologique accrue due au nombre de dépôts sous vide et au nombre de pas de masquage nécessaires à la réalisation des transistors de l'écran, en plus de défauts tels que des lignes coupées, des court-circuits lignes colonnes ou des points défectueux. Les court-circuits entre lignes et colonnes viennent notamment de ce que les lignes et les colonnes sont formées sur une même plaque de verre.

Pour pallier ces problèmes technologiques, la présente invention propose une nouvelle structure d'afficheur matriciel à matériau électrooptique alliant les avantages de report des colonnes sur la paroi opposée à celle des lignes, de l'emploi de transistors et de leur réalisation en un seul niveau de masquage, les procédés connus de réalisation de commandes à transistors utilisant au moins deux niveaux de masquage.

Il s'agit d'un afficheur matriciel à matériau électrooptique comme défini dans la revendication 1 comportant un réseau matriciel de zones élémentaires d'image constituées par un matériau électrooptique placé entre deux électrodes. L'une de ces deux électrodes est constituée par une zone semiconductrice dopée transparente entourée complètement par une zone semiconductrice peu ou pas dopée constituant le canal d'un transistor de commande dont l'électrode forme la source ou le drain. L'afficheur comprend en outre des moyens d'adressage des électrodes qui permettent d'appliquer sélectivement en chaque zone un champ électrique adapté à l'image désirée.

Dans un afficheur selon l'invention, l'adressage des lignes et l'adressage des colonnes se font de part et d'autre du matériau électrooptique. Les informations sont introduites de préférence dans des colonnes d'électrodes transparentes déposées sur un substrat en verre. Pour transmettre ces informations aux pixels d'une ligne donnée il est nécessaire de commander les électrodes semiconductrices dopées définissant les électrodes de lignes. Pour cela les zones peu ou pas dopées peuvent être recouvertes d'une grille métallique qui lorsqu'elle est mise sous tension permet de rendre le canal du transistor conducteur et par la même assure la conduction entre la source et le drain donc entre deux électrodes de pixel. La structure de grille associée aux zones peu ou pas dopées peut être représentée par une échelle dont les montants matérialisent une ligne d'adressage et dont les barreaux permettent de séparer les pixels adjacents d'une même ligne. Les pixels d'une autre ligne sont définis par une autre échelle non reliée électriquement à la première.

Lorsque l'échelle est mise sous tension les électrodes de la ligne associées aux électrodes de colonnes permettent de charger les pixels de la ligne considérée. Lorsque la ligne n'est plus adressée, les charges restent bloquées sur les électrodes semiconductrices de pixel et les informations restent ainsi inscrites jusqu'à un nouvel adressage de la ligne donc jusqu'à l'introduction de nouvelles informations. Toutefois, la mémoire des pixels est liée à des courants de fuite devant être négligeables au niveau du canal du transistor.

D'autres variantes d'afficheur selon l'invention peuvent être représentées par des structures de grilles (associées aux zones peu ou pas dopées) en quinconce ou nid d'abeille, la linéarité et l'orthogonalité des pixels n'étant pas nécessaire.

En principe, les zones peu ou pas dopées formant le canal des transistors d'accès sont déposées sur un substrat de verre et recouvertes d'une couche d'isolant de grille elle-même recouverte d'une grille conductrice (structure MOS directe). Mais les transistors peuvent également être des transistors en couche mince de type à structure étagée inverse. Dans cette structure la grille est déposée sur un substrat et enterrée en dessous des couches isolantes de grille, et semiconductrice .

Le semiconducteur employé pouvant être localement dopé est de préférence du silicium amorphe dopé par une présensibilisation du substrat au phosphore ou par implantation classique. Il peut également s'agir de silicium polycristallin ou bien encore de semiconducteurs organiques tels que le tétrathiofulvalene (TTF) ou le tétracyanoquinodiméthane (TCNQ). Il doit permettre de réaliser des électrodes de pixel transparentes pour permettre à la lumière de traverser l'afficheur.

La présente invention a encore pour objet le procédé de fabrication d'un afficheur selon l'invention, comprenant la formation de deux réseaux d'électrodes d'application de champ électrique sur des substrats séparés et la mise en place d'un matériau électrooptique entre les deux substrats, la formation d'un des réseaux comprenant la réalisation de transistors d'accès individuel pour commander chaque pixel.

Ce procédé comprend notamment les étapes suivantes :
- Dans un ordre quelconque : d'une part, former une couche semiconductrice peu ou pas dopée qui constituera localement le canal de transistors, et d'autre part déposer et graver les grilles de commande de ces transistors, la grille étant constituée en forme d'échelle avec des montants en ligne et des barreaux transversaux reliant les montants, l'espace entre deux barreaux consécutifs définissant un pixel séparé d'un pixel voisin par un des deux barreaux.
- doper les parties de couche semiconductrice non dopées, en utilisant comme masque les grilles de commande de conduction.

La présente invention sera mieux comprise et d'autres avantages apparaîtront à la lecture de la description qui va suivre et des figures annexées parmi lesquelles :
- la figure 1 représente un afficheur matriciel à cristal liquide selon l'art connu, utilisant des transistors ;
- la figure 2 représente le substrat (I₂) supportant les colonnes d'électrodes d'un afficheur selon l'invention ;
- la figure 3 représente le substrat (I₃) ainsi que ces électrodes semiconductrices associées à des transistors dans une variante d'afficheur selon l'invention ;
- la figure 4 illustre un exemple d'afficheur selon l'invention dans lequel le substrat (I₃) et ses électrodes sont celles représentées à la figure 3.

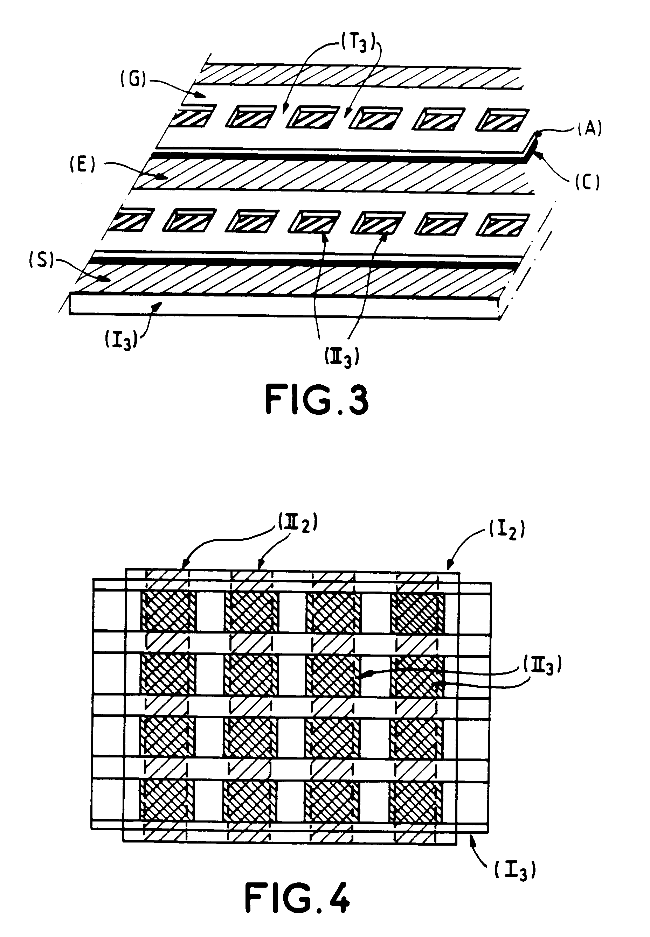

Dans un afficheur selon l'invention, le matériau électrooptique est inséré entre un substrat (I₂) comportant les colonnes d'électrodes (II₂) (figure 2) et un substrat (I₃) comportant les électrodes (II₃) semiconductrices et les transistors de commandes (T₃). Ces transistors peuvent être à structure étagée directe, la grille étant déposée sur le semiconducteur ou à structure étagée inverse, la grille étant enterrée sous le semiconducteur. La figure 3 illustre un exemple de réalisation de substrat (I₃) avec ses électrodes (II₃) utilisé dans un afficheur selon l'invention. Sur ce substrat, la grille est représentée par une échelle métallique, les espaces internes définis par les montants et les barreaux matérialisent les électrodes (II₃). Dans cet exemple de réalisation les transistors sont à structure étagée directe. La grille métallique (G) est déposée sur une échelle isolante de grille (A), elle-même déposée sur un matériau semiconducteur (S), préalablement déposé sur le substrat (I₃). Les électrodes (II₃) définies par l'intérieur des barreaux d'échelle ont une conductivité s supérieure à la conductivité sₒ des zones semiconductrices (C) qui sont en regard de l'échelle isolante (A). L'espace (E) entre échelles ayant également une conductivité s, on peut porter la couche de matériau semiconducteur à un potentiel déterminé V, lorsque la grille (G) est mise sous tension, les transistors deviennent passants et les électrodes (II₃) sont ainsi portées au potentiel V, les informations transmises par les colonnes d'électrodes sont alors affichées sur les pixels de la ligne adressée. L'afficheur ainsi réalisé avec un matériau électrooptique inséré entre les substrats (I₂) et (I₃) est représenté à la figure 4.

On peut aussi considérer le cas de fonctionnement où les potentiels des différentes colonnes sont alternés ; le déplacement de charges se fait alors essentiellement horizontalement entre pixels voisins. Le rôle des zones (E) est de ramener l'ensemble au potentiel V en cas de dérive.

Il est également possible de remplacer les électrodes colonnes transparentes par des électrodes réflectrices afin d'utiliser l'écran dans ce mode.

Ce type d'afficheur utilise préférentiellement un matériau cristal liquide pouvant être un nématique en hélice. Le semiconducteur employé peut être de nature variée il doit néanmoins répondre de préférence aux critères suivants :
- présenter une bonne transparence à la lumière ;
- avoir une conductivité s au moins égale à 1 microsiemens et posséder une fuite de canal inférieure à quelques femtoampères par micron pour permettre le stockage des informations lorsqu'une ligne a cessé d'être adressée.

La présente invention a également pour objet le procédé de réalisation de cet afficheur, ce procédé utilise comme masque les grilles (G) de transistors pour définir les électrodes semiconductrices (I₃) permettant un autoalignement de la source et du drain d'un transistor.

Plus précisément, les grilles de commande servent de masque pour doper les parties de couche semiconductrice qui ne sont pas en regard des grilles. La nature et la réalisation du dopage sont adaptées à la structure directe ou inverse des transistors ainsi qu'à la nature du semiconducteur employé.

Dans le cas du silicium amorphe ou polycristallin, pour une structure directe de transistors les techniques classiques d'implantation de phosphore permettent de doper les régions adjacentes à la grille afin d'obtenir des régions dopées n⁺ qui forment les électrodes de pixel et l'espace entre deux lignes adjacentes.

Dans le procédé selon l'invention on dépose sur une plaque de verre une couche semiconductrice par exemple du silicium polycristallin peu dopé, le dopage étant choisi en fonction de la conductivité sous le canal.

On forme une couche mince isolante, par exemple de l'oxyde de silicium, cette couche servant d'isolant de grille du transistor.

On dépose alors une couche métallique par photolithographie afin de définir les échelles constituant les grilles des transistors ainsi que les échelles d'isolant de grilles.

Le dopage peut alors être effectué par implantation classique de phosphore dans le cas où le matériau semiconducteur est du silicium, permettant de doper les régions constituant les électrodes de pixel et l'espace entre deux lignes adjacentes. La grille métallique sert de masque durant l'opération du dopage, les zones semiconductrices en regard des montants et des barreaux d'échelle restant par conséquent peu dopées.

Le réseau d'électrodes de pixel (II₃) ainsi défini sur le substrat (I₃) est superposé au réseau d'électrodes colonnes (II₂) réalisé sur le substrat (I₂). Le matériau électrooptique est inséré entre ces deux substrats et l'ensemble réalise un afficheur matriciel à matériau électrooptique.

Dans le cas d'une structure étagée inverse, une couche de phosphore peut être déposée préalablement sur une couche de silicium, la grille étant déposée sur le substrat (I₃) et enterrée sous la couche de semiconducteur. La diffusion de phosphore dans le semiconducteur peut être réalisée au travers du substrat (I₃) par un faisceau laser qui provoque un échauffement capable de générer le dopage, ce faisceau laser étant par contre réfléchi par la grille métallique. Il est aussi possible de faire après dépôt et gravure des couches métallique et isolante le dépôt sélectif de phosphore sur le substrat et non sur l'isolant. Le procédé est suivi du dépôt silicium et de la diffusion thermique du phosphore. Le procédé d'autoalignement de la source et du drain soit encore de deux électrodes de pixel de ligne peut ainsi être obtenu que la structure des transistors soit directe ou inverse.

## Revendications

1. Afficheur matriciel à matériau électrooptique, comportant un réseau matriciel de zones élémentaires d'image, et dans chaque zone élémentaire un matériau électrooptique placé entre deux électrodes (II₂ et II₃), l'image affichée en chaque zone étant fonction du champ électrique applicable entre les deux électrodes situées dans cette zone, et des moyens d'adressage des électrodes étant prévus pour appliquer sélectivement en chaque zone un champ électrique désiré, caractérisé en ce que l'une des deux électrodes (II₂ ou II₃) est constituée par une zone semiconductrice dopée transparente entourée complètement par une zone semiconductrice peu ou pas dopée constituant le canal d'un transistor de commande (T₃) dont l'électrode forme la source ou le drain.

2. Afficheur selon la revendication 1, caractérisé en ce que le matériau électrooptique est inséré entre un substrat (I₂) sur lequel sont définies des colonnes d'électrodes transparentes (II₂) et un substrat (I₃) sur lequel sont définies des électrodes de lignes (II₃) semiconductrices et transparentes avec des transistors (T₃) dont les grilles (G) sont associées en regard des zones peu ou pas dopées.

3. Afficheur selon la revendication 2, caractérisé en ce que l'ensemble des grilles (G) d'une ligne est défini par une structure d'échelle dont les barreaux séparent deux électrodes de ligne, les montants définissant une ligne d'adressage.

4. Afficheur selon l'une des revendications 1 à 3, caractérisé en ce que le matériau électrooptique est un cristal liquide.

5. Afficheur selon la revendication 4, caractérisé en ce que le cristal liquide est un nématique en hélice.

6. Afficheur selon l'une des revendications 1 à 5, caractérisé en ce que le semiconducteur est du silicium amorphe ou polycristallin.

7. Afficheur selon l'une des revendications 1 à 6, caractérisé en ce que les transistors sont à structure étagée directe la grille (G) étant déposée sur un isolant de grille lui-même déposé sur les zones peu ou pas dopées.

8. Afficheur selon l'une des revendications 1 à 6, caractérisé en ce que les transistors (T₃) sont à structure étagée inverse, la grille (G) étant déposée sur le substrat (I₃) et enterrée sous l'isolant de grille et le semiconducteur.

9. Afficheur selon la revendication 8, caractérisé en ce que le semiconducteur est du silicium dopé au phosphore sous l'action d'un laser opérant au travers du substrat (I₃).

10. Afficheur selon la revendication 8, caractérisé en ce que le dépôt sélectif de phosphore sur le substrat est effectué après le dépôt et la gravure des couches métallique et isolante, le silicium étant ensuite déposé sur l'ensemble, et localement dopé par diffusion thermique du phosphore.

11. Procédé de fabrication d'un afficheur matriciel, comprenant la formation de deux réseaux d'électrodes d'application de champ électrique sur des substrats séparés (I₂ et I₃) et la mise en place d'un matériau électrooptique entre les substrats, la formation d'un des deux réseaux d'électrodes (II₃) comprenant la réalisation de transistors d'accès individuel pour commander chaque pixel, comprenant les étapes suivantes :
- dans un ordre quelconque : d'une part, former une couche semiconductrice peu ou pas dopée qui constituera localement le canal de transistors, et d'autre part déposer et graver les grilles de commande de ces transistors, la grille étant constituée en forme d'échelle avec des montants en ligne et des barreaux transversaux reliant les montants, l'espace entre deux barreaux consécutifs définissant un pixel séparé d'un pixel voisin par un des deux barreaux.
- doper les parties de couche semiconductrice non dopées, en utilisant comme masque les grilles de commande de conduction .

## Patentansprüche

1. Matrixartiger Bildschirm mit elektro-optischem Material, der ein matrixförmiges Netz von elementaren Bildzonen und in jeder elementaren Bildzone ein elektro-optisches Material zwischen zwei Elektroden (II₂, II₃) besitzt, wobei das in jeder Zone angezeigte Bild vom elektrischen Feld abhängt, das zwischen die beiden in dieser Zone liegenden Elektroden angelegt werden kann, wobei Mittel zum Adressieren der Elektroden vorgesehen sind, um selektiv in jeder Zone ein gewünschtes elektromagnetisches Feld anzulegen, dadurch gekennzeichnet, daß eine der beiden Elektroden (II₂ oder II₃) von einer transparenten halbleitenden und dotierten Zone gebildet wird, die ganz von einer wenig oder gar nicht dotierten halbleitenden Zone umgeben ist, welche den Kanal eines Steuertransistors (T₃) bildet, dessen Elektrode die Source- oder Drainelektrode bildet.

2. Bildschirm nach Anspruch 1, dadurch gekennzeichnet, daß das elektro-optische Material zwischen ein Substrat (I₂), auf dem die transparenten Elektrodenspalten (II₂) ausgebildet sind, und ein Substrat (I₃) eingefügt ist, auf dem transparente und halbleitende Zeilenelektroden (II₃) mit Transistoren (T₃) definiert sind, deren Gates (G) gegenüber den wenig oder gar nicht dotierten Zonen liegen.

3. Bildschirm nach Anspruch 2, dadurch gekennzeichnet, daß die Gesamtheit der Gates (G) einer Zeile durch eine Leiterstruktur definiert ist, deren Sprossen zwei Zeilenelektroden voneinander trennen und deren Wangen eine Adressenzeile definieren.

4. Bildschirm nach einem der Ansprüche 1 bis 3, dadurch gekennzeichnet, daß das elektro-optische Material ein Flüssigkristall ist.

5. Bildschirm nach Anspruch 4, dadurch gekennzeichnet, daß der Flüssigkristall ein nematischer Kristall mit Spiralstruktur ist.

6. Bildschirm nach einem der Ansprüche 1 bis 5, dadurch gekennzeichnet, daß der Halbleiter aus amorphem oder polykristallinem Silizium ist.

7. Bildschirm nach einem der Ansprüche 1 bis 6, dadurch gekennzeichnet, daß die Transistoren eine gestufte direkte Struktur haben, wobei das Gate (G) auf einer Gateisolierung liegt, die ihrerseits auf den wenig oder gar nicht dotierten Zonen liegt.

8. Bildschirm nach einem der Ansprüche 1 bis 6, dadurch gekennzeichnet, daß die Transistoren (T₃) eine invers gestufte Struktur besitzen, wobei das Gate (G) auf das Substrat (I₃) aufgebracht und unter der Gateisolierung und dem Halbleiter eingebettet ist.

9. Bildschirm nach Anspruch 8, dadurch gekennzeichnet, daß der Halbleiter aus mit Phosphor dotiertem Silizium besteht, wobei die Dotierung mit einem Laser folgt, der durch das Substrat (I₃) hindurch wirkt.

10. Bildschirm nach Anspruch 8, dadurch gekennzeichnet, daß der Phosphor selektiv auf das Substrat nach dem Aufbringen und Ausätzen der Metallschicht und der Isolierschicht aufgebracht wird und daß das Silizium dann auf die ganze Einheit aufgebracht und örtlich durch thermische Diffusion des Phosphors dotiert wird.

11. Verfahren zur Herstellung eines matrixartigen Bildschirms, bei dem zwei Netze von Elektroden zum Anlegen elektrischer Felder an getrennte Substrate (I₂ und I₃) gebildet werden und ein elektro-optisches Material zwischen die Substrate eingefügt wird, wobei die Bildung eines der beiden Elektrodennetze (II₃) die Herstellung von einzelnen Zugangstransistoren zur Steuerung jedes Pixels beinhaltet und das Verfahren folgende Schritte enthält:
- in einer beliebigen Reihenfolge wird eine wenig oder gar nicht dotierte Halbleiterschicht ausgebildet, die später örtlich den Kanal von Transistoren bildet, und dann werden die Steuergates dieser Transistoren aufgebracht und ausgeätzt, wobei die Gates in Form einer Leiter mit Wangen in Zeilenrichtung und die Wangen verbindende Quersprossen gebildet werden und der Raum zwischen zwei aufeinanderfolgenden Sprossen ein von einem Nachbarpixel durch eine der Sprossen getrenntes Pixel definiert,
- die nicht dotierten Bereich der Halbleiterschicht werden dotiert, indem als Maske die Steuergates verwendet werden.

## Claims

1. Matrix display with electrooptical material, including a matrix array of elementary image regions and, in each elementary region, an electrooptical material placed between two electrodes (II₂ and II₃), the image displayed at each region being a function of the electric field applicable between the two electrodes situated in this region, and means for addressing the electrodes being provided in order selectively to apply a desired electric field in each region, characterized in that one of the two electrodes (II₂ or II₃) consists of a transparent doped semiconducting region completely surrounded by a lightly or non-doped semiconducting region constituting the channel of a control transistor (T₃) the electrode of which forms the source or the drain.

2. Display according to Claim 1, characterized in that the electrooptical material is inserted between a substrate (I₂) on which transparent electrode columns (II₂) are defined and a substrate (I₃) on which semiconducting and transparent row electrodes (II₃), with transistors (T₃) the gates (G) of which are associated with regard to lightly or non-doped regions.

3. Display according to Claim 2, characterized in that the set of gates (G) of one row is defined by a ladder structure the rungs of which separate two row electrodes, the uprights defining one addressing row.

4. Display according to one of Claims 1 to 3, characterized in that the electrooptical material is a liquid crystal.

5. Display according to Claim 4, characterized in that the liquid crystal is a twisted nematic liquid crystal.

6. Display according to one of Claims 1 to 5, characterized in that the semiconductor is amorphous or polycrystalline silicon.

7. Display according to one of Claims 1 to 6, characterized in that the transistors have a direct stepped structure, the gate (G) being deposited on a gate insulant which is itself deposited on the lightly or non-doped regions.

8. Display according to one of Claims 1 to 6, characterized in that the transistors (T₃) have an inverse stepped structure, the gate (G) being deposited on the substrate (I₃) and buried under the gate insulant and the semiconductor.

9. Display according to Claim 8, characterized in that the semiconductor is silicon doped with phosphorus under the action of a laser operating through the substrate (I₃).

10. Display according to Claim 8, characterized in that the selective deposition of phosphorus on the substrate is performed after the deposition and the etching of the metal and insulant layers, the silicon then being deposited on the assembly, and locally doped by thermal diffusion of phosphorus.

11. Method of manufacturing a matrix display, comprising the formation of two arrays of electrodes for applying an electric field to separate substrates (I₂ and I₃), and the placing of an electrooptical material between the substrates, the formation of one of the two electrode arrays (II₃) comprising the production of individual access transistors for controlling each pixel, comprising the following steps:
- in any order: on the one hand, forming a lightly or non-doped semiconducting layer which will locally constitute the transistor channel, and, on the other hand, depositing and etching the control gates of these transistors, the gate being constructed in the form of a ladder with uprights in line and transversal rungs linking the uprights, the space between two consecutive rungs defining a pixel separated from an adjacent pixel by one of the two rungs.
- doping the non-doped semiconducting layer parts, using the conduction control gates as a mask.
